# EUROPEAN PATENT SPECIFICATION

(11) **EP 4 319 528 B1**
(45) Date of publication and mention of the grant of the patent: **06.05.2026**
(21) Application number: 22835200.1
(22) Date of filing: 01.08.2022
(51) Int. Cl.: H10B 12/00

(54) **SEMICONDUCTOR STRUCTURE AS WELL AS MANUFACTURING METHOD THEREFOR, STORAGE CHIP, AND ELECTRONIC DEVICE**
HALBLEITERSTRUKTUR UND VERFAHREN ZUR HERSTELLUNG EINER HALBLEITERSTRUKTUR, SPEICHERCHIP UND ELEKTRONISCHE VORRICHTUNG
STRUCTURE SEMI-CONDUCTRICE, SON PROCÉDÉ DE FABRICATION, PUCE DE STOCKAGE ET DISPOSITIF ÉLECTRONIQUE

(30) Priority: 21.06.2022 CN 202210723121
(43) Date of publication of application: 07.02.2024
(73) Proprietor: Changxin Memory Technologies, Inc., Hefei City, Anhui 230601 (CN)
(72) Inventor: WANG, Hong, Hefei, Anhui 230601 (CN); LI, Xiaojie, Hefei, Anhui 230601 (CN)
(74) Representative: Gulde & Partner
(86) International application number: PCT/CN2022/109539
(87) International publication number: WO 2023/245818

(56) References cited:
- CN-A- 109 841 630
- CN-A- 110 914 994
- CN-A- 114 068 568
- US-A1- 2019 164 985
- US-A1- 2021 159 229
- US-A1- 2022 130 831
- US-A1- 2022 130 831

## Description

### CROSS-REFERENCE TO RELATED APPLICATION

The present application claims priority to Chinese Patent Application No. 202210723121.3, filed on June 21, 2022 and entitled "SEMICONDUCTOR STRUCTURE AND METHOD FOR MANUFACTURING SAME, MEMORY CHIP AND ELECTRONIC DEVICE".

### TECHNICAL FIELD

The embodiments of the disclosure belong to the field of semiconductors and particularly relate to a semiconductor structure and a method for manufacturing the semiconductor structure, a memory chip and an electronic device.

### BACKGROUND

A semiconductor structure includes a plurality of memory cells, and the memory cells are connected to a peripheral circuit to execute a storage function. With an improvement of an integration level of the semiconductor structure, the number of the memory cells capable of being accommodated in the semiconductor structure increases and the performance of the semiconductor structure gets better. However, many spaces in the current semiconductor structure are wasted. Besides, under the limit of factors of physical properties, the volume of the memory cell has reached a scaling limit. Under the limit of process factors, it is also difficult to increase the number of stacked layers of the memory cell. Background may be found in US 2022/130831 A1 (LEE SI-WOO [US] ET AL) 28 April 2022 and US 2019/164985 A1 (LEE KISEOK [KR] ET AL) 30 May 2019.

Therefore, it is urgent to provide a semiconductor structure in a new architecture, so as to improve the integration level of the semiconductor structure.

### SUMMARY

The present invention is defined in appended independent claims 1 and 14 to which reference should be made. Advantageous features are set out in the appended dependent claims.

### BRIEF DESCRIPTION OF THE DRAWINGS

The accompanying drawings, which are incorporated in and constitute a part of this specification, illustrate embodiments conforming to the disclosure and, together with the description, serve to explain the principles of the disclosure. It is apparent that the accompanying drawings described below merely show some embodiments of the disclosure, and those of ordinary skill in the art can further obtain other drawings according to those accompanying drawings without making creative efforts.
FIG. 1 illustrates a top view of a semiconductor structure.
FIG. 2 illustrates an enlarged partial view of FIG. 1.
FIG. 3 illustrates a sectional view along a direction A-A1 of FIG. 2.
FIG. 4 illustrates a schematic diagram of a stacked structure provided by an embodiment of the disclosure.
FIG. 5 to FIG. 11 respectively illustrate partial plan views of seven different semiconductor structures provided by the embodiments of the disclosure.
FIG. 12 illustrates a schematic diagram of a memory cell group provided by an embodiment of the disclosure.
FIG. 13 illustrates a schematic partial side view of a semiconductor structure provided by an embodiment of the disclosure.
FIG. 14 illustrates a schematic diagram of another memory cell group provided by an embodiment of the disclosure.
FIG. 15 illustrates a schematic partial side view of another memory cell group provided by the embodiment of the disclosure.
FIG. 16 illustrates a schematic diagram of another memory cell group provided by an embodiment of the disclosure.
FIG. 17 illustrates a schematic partial side view of another semiconductor structure provided by an embodiment of the disclosure.
FIG. 18 to FIG. 21 respectively illustrate schematic diagrams of four memory cell groups provided by the embodiments of the disclosure.
FIG. 22 shows a schematic diagram of a structure module provided by an embodiment of the disclosure.
FIG. 23 to FIG. 31 illustrate schematic structural diagrams corresponding to stairs in a method for manufacturing a semiconductor structure provided by the embodiments of the disclosure.
FIG. 32 to FIG. 35 illustrate schematic structural diagrams corresponding to stairs in another method for manufacturing a semiconductor structure provided by the embodiments of the disclosure.
FIG. 36 illustrates a schematic diagram of another memory cell group provided by an embodiment of the disclosure.
FIG. 37 to FIG. 38 respectively illustrate partial top views of two different semiconductor structures provided by the embodiments of the disclosure.

### DETAILED DESCRIPTION

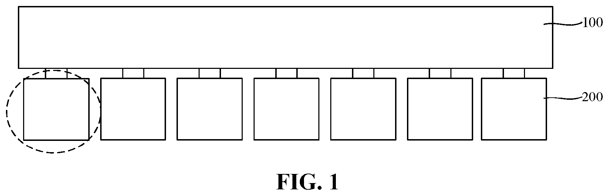

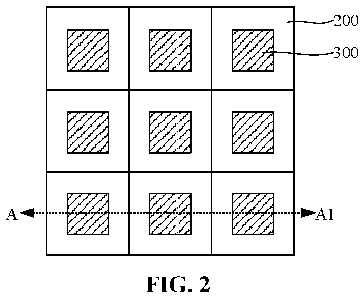

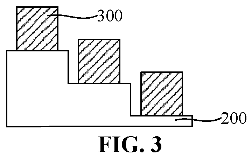

FIG. 1 is a top view of a semiconductor structure. FIG. 2 is an enlarged view of a stair in a dotted line circle in FIG. 1. FIG. 3 is a sectional view along a direction A-A1 in FIG. 2. Referring to FIG. 1 to FIG. 3, the semiconductor structure includes a memory cell area 100 and a staircase 200. Multiple layers of memory cells are provided in the memory cell area 100. Multiple stairs are arranged in the staircase 200, and the stairs and the multiple layers of memory cells are arranged in one-to-one correspondences. A connecting layer (not shown FIG. 1 to FIG. 3) can be arranged in the stair, a leading wire post 300 can be arranged on the stair, and the leading wire post 300 is electrically connected to the memory cell through the connecting layer in the stair to lead out the memory cell, to connect the memory cell to a peripheral circuit. However, with an increase of the number of stacked layers of the memory cells, the area occupied by the staircase 200 is getting large. For example, if there are totally 64 layers of memory cells, 64 stairs are needed correspondingly, and the lower the stair is, the larger the area of the stair is. If the area of the topmost stair is 0.25µm², the stair of the bottommost stair is 64*0.25=16µm². Referring to FIG. 3, the connecting layer below each stair is only used for support and electric connection, so that the bottom space is wasted. Therefore, the integration level of the semiconductor structure is to be further improved.

An embodiment of the disclosure provides a semiconductor structure. In the semiconductor structure, at least two leading wire posts of the plurality of leading wire posts are in contact with the different layers of memory cells in different memory cell groups. That is, at least two leading wire posts directly contact with to the memory cells, to reduce the number of stairs or it is no longer to arrange a separate staircase, thereby improving a spatial utilization ratio, and improving an integration level of the semiconductor structure.

The embodiments of the disclosure are described below in detail in combination with the drawings. However, those of ordinary skill in the art may understand that many technical details are provided to better understand the embodiments of the disclosure. However, the technical solutions claimed by the disclosure may also be implemented based on various changes and modifications of the following embodiments without these technical details.

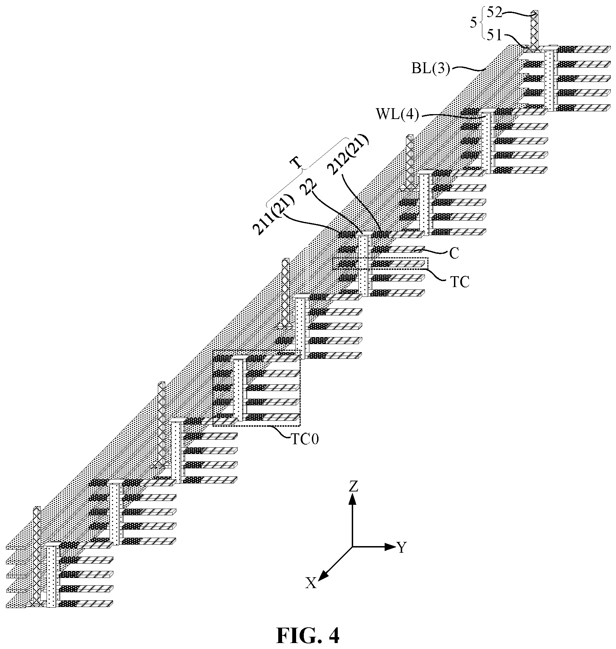

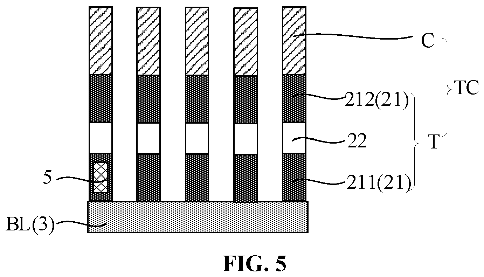

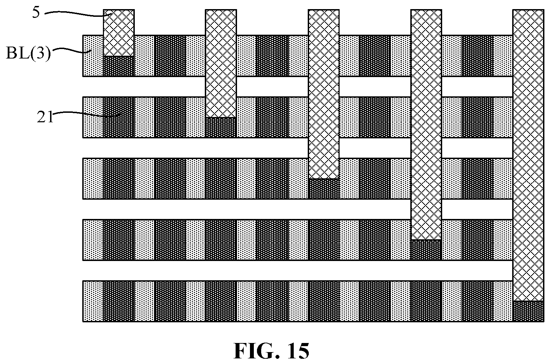

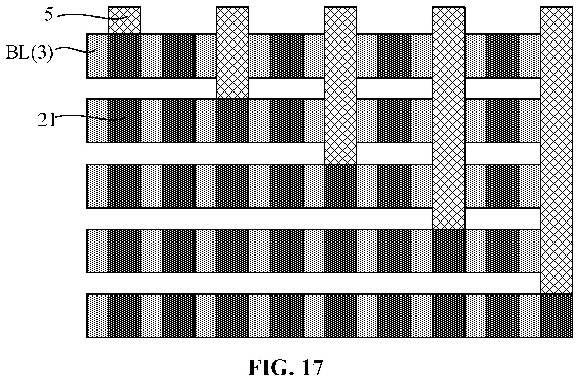

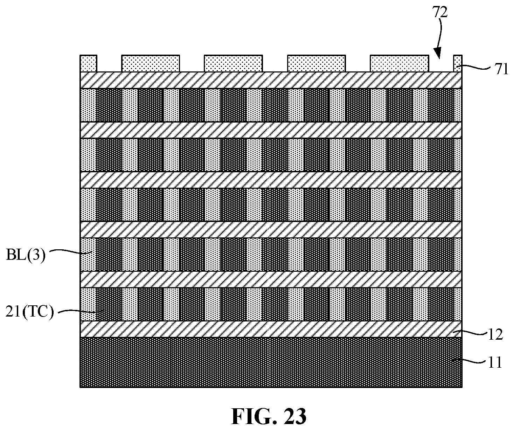

As shown in FIG. 4 to FIG. 22, an embodiment of the disclosure provides a semiconductor structure. The semiconductor structure includes: a substrate 11 (referring to FIG. 23) on which a stacked structure is provided. The stacked structure includes multiple memory cell groups TC0 arranged in a first direction X, and the memory cell group TC0 includes multiple layers of memory cells TC arranged in a second direction Z. The semiconductor structure further includes multiple leading wire posts 5. At least two leading wire posts 5 are respectively in contact with different layers of memory cells TC in different memory cell groups TC0.

That is, the memory cells TC are stacked in multiple layers, and at least two leading wire posts 5 are directly in contact with the memory cells TC, to reduce the number of stairs. In a case that all the leading wire posts 5 are directly in contact with the memory cells TC, it is not required to arrange the separate staircase. That is, orthographic projections of the leading wire post 5 in contact with the memory cell TC on a surface of the substrate 11 are within orthographic projection of the stacked structure on the surface of the substrate 11, which can improve a utilization degree of the surface of the substrate 11, and further improve an integration level of the semiconductor structure. In addition, at least two leading wire posts 5 are in contact with different layers of memory cells TC in different memory cell groups TC0. This indicates that at least two leading wire posts 5 utilize the space of different memory cell groups TC0.

The semiconductor structure is described below in detail in combination with the drawings.

In some embodiments, referring to FIG.4 to FIG.5 and FIG. 8 to FIG. 22, all the memory cells TC in the same memory cell group TC0 are in contact with no more than one leading wire post 5. That is, only one contact position of the leading wire post 5 to the memory cell TC is arranged in each memory cell group TC0. Since the contact position in the same memory cell group TC0 is few, connection modes in different memory cell groups TC0 are relatively unified. Therefore, the connection process between different leading wire posts 5 and memory cells TC can be unified, thereby lowering the production cost. It is to be noted that in order to make the leading wire post 5 contact with different layers of memory cells TC, a part of structure in the memory cell TC can be removed, so that at least a part of leading wire post 5 penetrate through at least one memory cell TC, and the leading wire post 5 may be arranged on a side wall of the memory cell TC and do not penetrate through the memory cell TC.

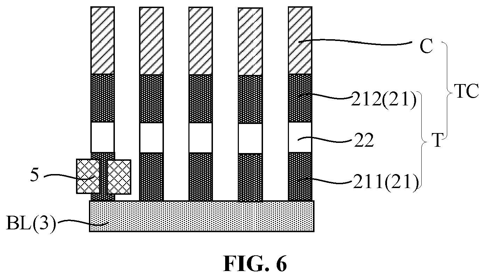

In some other embodiments, referring to FIG.6 to FIG. 7, the memory cells TC in contact with at least two leading wire posts 5 are located in the same memory cell group TC0. That is, multiple contact positions of the leading wire post 5 to the memory cell TC can be arranged in each memory cell group TC0. It is to be noted that in order to make the leading wire post 5 be in contact with the memory cell TC, a part of structure in the memory cell TC is removed, so as to provide space needed by the leading wire post 5. After the part of structure in the memory cell TC is removed, the memory cell TC may no longer execute the storage function. In a case that the multiple leading wire posts 5 are arranged in the same memory cell group TC0, the number of the invalid memory cells TC can be reduced, to improve a spatial utilization ratio in the semiconductor structure, thereby improving the integration level.

Specifically, the memory cells TC in the same memory cell group TC0 in contact with at least two leading wire posts 5 includes the following two conditions. At least two leading wire posts 5 in the same memory cell group TC0 are in contact with the same layer of memory cells TC, and at least two leading wire posts 5 in the same memory cell group TC0 are in contact with the different layers of memory cells TC.

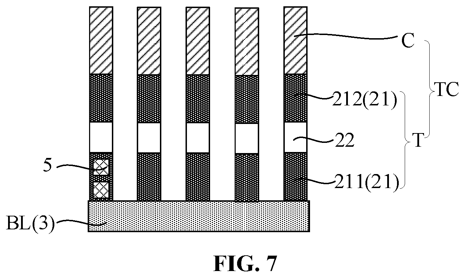

Referring to FIG. 6, at least two leading wire posts 5 in the same memory cell group TC0 may be arranged along the first direction X. Referring to FIG. 7, at least two leading wire posts 5 in the same memory cell group TC0 may be arranged along the third direction Y.

In some embodiments, referring to FIG. 4, the number of the leading wire posts 5 is equal to or greater than the number of layers of the memory cells TC, and each of the layers at least includes one memory cell TC in contact with the leading wire post 5. That is, the memory cell TC in each layer may be directly in contact with the leading wire post 5, and the separate staircase is not required. In addition, the memory cell TC in each layer may be led out through one or more leading wire posts 5. In a case that the memory cell TC in each layer is led out through one leading wire post 5, process manufacturing is simplified. In a case that the memory cell TC in each layer is led out through the plurality of leading wire posts 5, the contact area is increased, thereby reducing the contact resistance.

It is to be noted that the memory cell group TC0 includes various different structures inside. Therefore, in a case that there are too many leading wire posts 5 connected to the same memory cell group TC0, the space needed by the leading wire posts 5 is large. Different leading wire posts 5 may be connected to different structures in the memory cell group TC0. Different connection processes are adopted for different structures. In some embodiments, the number of the leading wire posts 5 connected to the same memory cell group TC0 is smaller than the number of layers of the memory cells TC in the memory cell group TC0. By controlling the number of the leading wire posts 5 connected to the same memory cell group TC0 to be kept in a reasonable range, the connection processes between the leading wire posts 5 and the memory cells TC is simplified.

In some embodiments, referring to FIG. 6 and FIG.8 to FIG.9, the leading wire posts 5 are arranged along the first direction X. That is, the plurality of leading wire posts 5 are substantially aligned in the first direction X, so that the plurality of leading wire posts 5 can be connected to the same structure in the memory cell TC, which unifies processes of connecting the leading wire posts 5 to the memory cells TC, and thus lowers the production cost.

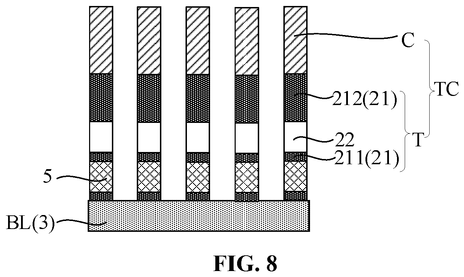

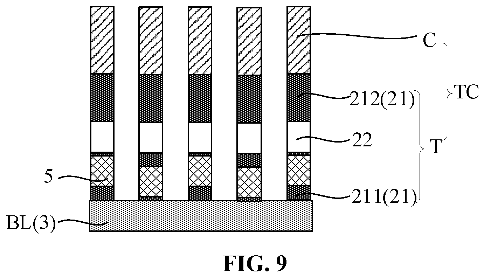

For example, referring to FIG. 8, the leading wire posts 5 are lined up along the first direction X. In other words, the leading wire posts 5 are arranged in a straight line, and two ends of the plurality of leading wire posts 5 are aligned in the first direction X, which simplifies the process and improves the uniformity of the semiconductor structure. In addition, referring to FIG. 9, the leading wire posts 5 may further be slightly staggered, that is, two ends of the plurality of leading wire posts 5 are not aligned in the first direction X, to reduce the area of a directly facing region between the leading wire posts 5, thereby reducing parasitic capacitance between adjacent leading wire posts 5.

Referring to FIG. 4 and FIG.12 to FIG. 22, the at least one leading wire post 5 extends in the second direction Z and penetrates through at least one memory cell TC in the memory cell group TC0. In this case, the orthographic projection of the at least one leading wire post 5 on the surface of the substrate 11 is within the orthographic projection of the memory cell TC on the surface of the substrate 11. It will be described below in detail. In order to facilitate understanding, the leading wire post 5 is divided into a contact portion 51 and an extension portion 52 arranged in a stacked manner. The contact portion 51 is in contact with the memory cell TC, and the memory cell TC in contact with the contact portion 51 is called as the memory cell TC of a corresponding layer.

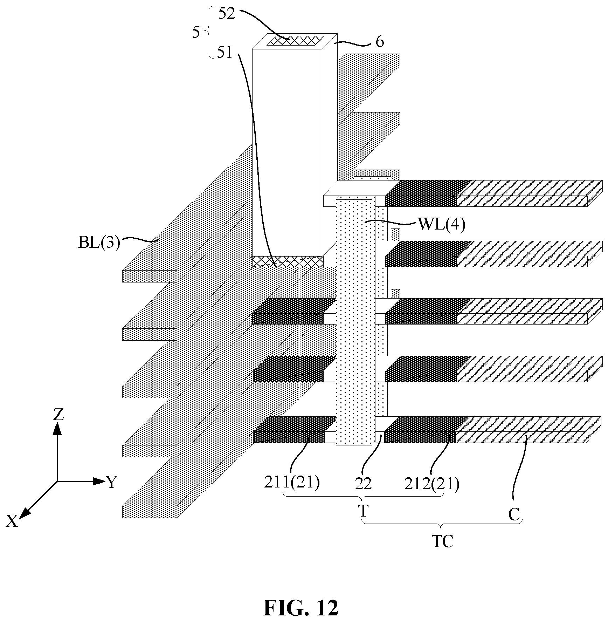

Specifically, at least two leading wire posts 5 are respectively in contact with different layers of memory cells TC in different memory cell groups TC0, which indicates that at least one leading wire post 5 is in contact with the memory cell TC of the non-top layer. The leading wire post 5 in contact with the memory cell TC of a non-top layer occupies a spatial position of the memory cell TC above the corresponding layer, in addition to spatial position of the memory cell TC of the corresponding layer. For example, referring to FIG. 12, FIG. 14 and FIG. 16, in a case that a secondary top layer is taken as the corresponding layer, the contact portion 51 of the leading wire post 5 is in contact with the memory cell TC of the secondary top layer, and the extension portion 52 of the leading wire post 5 penetrates through the memory cell TC of the top layer. The memory cell TC which is penetrated and the memory cell TC which is in contact with the leading wire post no longer have the storage function. In other words, a part of structure of the memory cell TC above the corresponding layer may be directly removed, to provide a spatial position to the extension portion 52 of the leading wire post 5, thereby simplifying the production process.

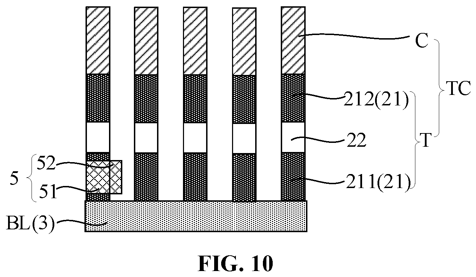

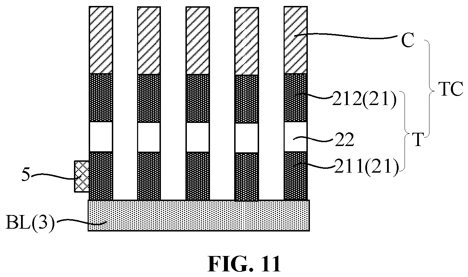

It is to be noted that in some other embodiments, the extension portion 52 of the leading wire post 5 may not occupy the spatial position of the memory cell TC above the corresponding layer but occupies a spatial position between the adjacent memory cells TC. Specifically, referring to FIG. 10, a part of contact portion 51 of the leading wire post 5 protrudes from the memory cell TC of the corresponding layer and is arranged in a space between the adjacent memory cells TC, so that the extension portion 52 of the leading wire post 5 may be led out upwards from a gap between the adjacent memory cells TC without penetrating through the memory cell TC above the corresponding layer, thereby decreasing the number of the invalid memory cells TC. Alternately, referring to FIG. 11, the contact portion 51 and the extension portion 52 of the leading wire post 5 are arranged in the space between the adjacent memory cells TC, and the contact portion 51 is in contact with the side wall of the memory cell TC of the corresponding layer, so that the extension portion 52 of the leading wire post 5 may be led out upwards from the gap between the adjacent memory cells TC without penetrating through the memory cell TC above the corresponding layer, thereby decreasing the number of the invalid memory cells TC.

Referring to FIG. 4, the leading wire post 5 in contact with the memory cell TC of the top layer only utilizes a spatial position of the memory cell TC of the corresponding layer rather than spatial positions of the other memory cells TC. Therefore, the leading wire post does not need penetrating through the memory cells TC of a layer rather than the corresponding layer.

It is to be noted that in some embodiments, referring to FIG. 4 and FIG.12 to FIG. 13, the leading wire post 5 may further penetrate through the memory cell TC of the corresponding layer, that is, a part of structure of the memory cell TC of the corresponding layer is removed to provide a spatial position to the contact portion 51 of the leading wire post 5. At the time, at least a part of side surface of the leading wire post 5 is in contact with the memory cell TC.

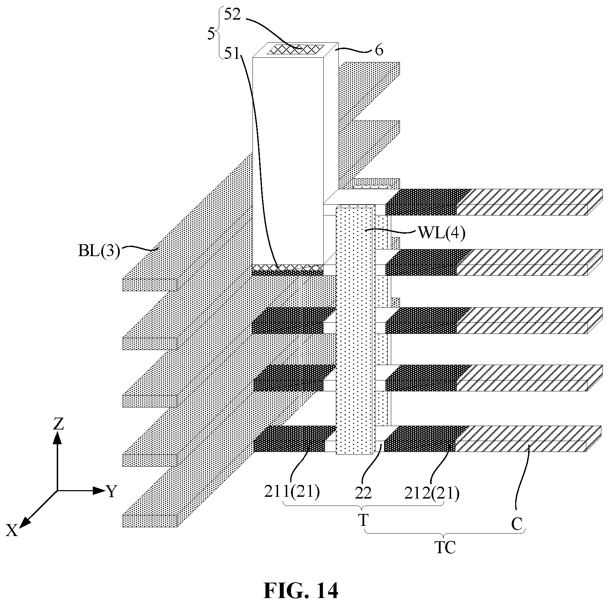

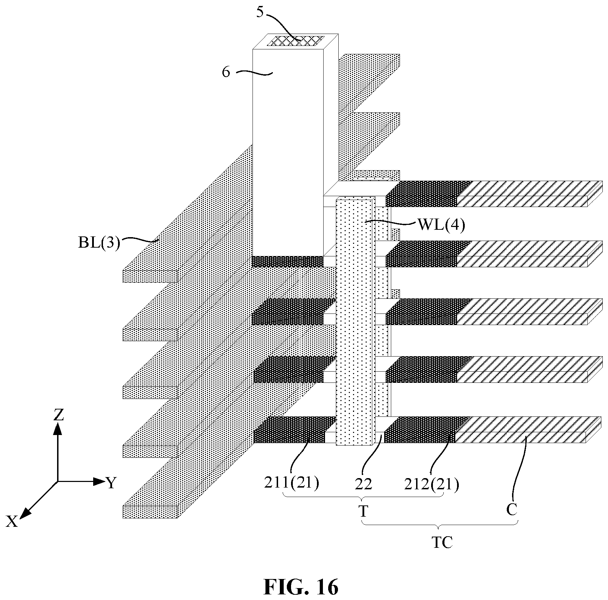

In some other embodiments, the leading wire post 5 may not penetrate through the memory cell TC of the corresponding layer. For example, referring to FIG. 14 to FIG. 15, the leading wire post 5 is embedded into the memory cell TC of the corresponding layer. In this case, a bottom surface and a part of a side surface of the leading wire post 5 are in contact with the memory cell TC. In addition, referring to FIG. 16 to FIG. 17, the bottom surface of the leading wire post 5 is in contact with a top surface of the memory cell TC of the corresponding layer.

Referring to FIG. 4, FIG. 13, FIG. 15 and FIG. 17, the numbers of the memory cells which at least two leading wire posts 5 penetrate through are different. That is, at least two leading wire posts 5 are in contact with different layers of memory cells TC, so as to lead out different layers of memory cells TC. In this way, at least two stairs may be decreased, so as to reduce the volume of the semiconductor structure.

Referring to FIG. 12, FIG. 14, FIG. 16 and FIG. 18 to FIG. 21, the semiconductor structure further includes a dielectric layer 6 arranged between the leading wire post 5 and the penetrated memory cell TC. The dielectric layer 6 may isolate the leading wire post 5 from the memory cell TC above the corresponding layer. It is to be noted that in a case that the leading wire post 5 further penetrates through the memory cell TC of the corresponding layer, the dielectric layer 6 is arranged between the leading wire post 5 and the memory cell TC above the corresponding layer, and a side of the leading wire post 5 located in the memory cell TC of the corresponding layer is exposed, so that the leading wire post 5 is in contact with the memory cell TC of the corresponding layer through the side wall.

Referring to FIG. 4, the two adjacent leading wire posts 5 are at least spaced by one memory cell group TC0. That is, the adjacent two leading wire posts 5 are not in contact with the adjacent memory cell groups TC0, to increase a distance between the adjacent leading wire posts 5, thereby reducing the parasitic capacitance.

Specifically, in some examples, the number of the memory cell groups TC0 between adjacent two leading wire posts 5 is fixed, that is, a distance between the adjacent leading wire posts 5 is fixed, thereby improving the uniformity of the semiconductor structure. In some other examples, the area of a directly facing region between the two adjacent leading wire posts 5 are directly proportional to the number of the memory cell groups TC0 between the two adjacent leading wire posts 5. It may be understood that the parasitic capacitance between the adjacent leading wire posts 5 is related to the area of a directly facing region between the two adjacent leading wire posts 5. With an increase of the area of a directly facing region between the two adjacent leading wire posts 5, the number of the memory cell groups TC0 between the two adj acent leading wire posts 5 may be correspondingly increased to increase the distance between the two adjacent leading wire posts 5, so as to reduce the parasitic capacitance. Exemplarily, two leading wire posts 5 in contact with the memory cells TC of the bottom layer and the secondary bottom layer are adjacently arranged, and five memory cell groups TC0 are arranged between the two leading wire posts 5. Two leading wire posts 5 in contact with the memory cells TC of the top layer and the secondary top layer are adjacently arranged, and one memory cell group TC0 is arranged between the two leading wire posts 5.

In some other embodiments, referring to FIG.8 to FIG. 9, the adjacent two leading wire posts 5 may further be arranged on the adjacent memory cell groups TC0, and there is no memory cell group TC0 between the adjacent two leading wire posts 5.

The stacked structure is specifically described below.

Referring to FIG. 4, the semiconductor structure has the first direction X, the second direction Z and the third direction Y inside. The first direction X is parallel to the surface of the substrate 11, the second direction Z is perpendicular to the surface of the substrate 11, and the third direction Y is parallel to the surface of the substrate 11. The third direction Y is different from the first direction X. Exemplarily, the third direction Y is perpendicular to the first direction X.

Continuously referring to FIG. 4, the stacked structure further includes a plurality of horizontal signal lines 3 and a plurality of vertical signal lines 4. The plurality of horizontal signal lines 3 are arranged in the second direction Z and extend along the first direction X, and are in contact with one layer of the memory cells TC. The vertical signal lines 4 extend along the second direction Z and are in contact with the multiple layers of memory cells TC of the same memory cell group TC0. The leading wire posts 5 are electrically in contact with the horizontal signal lines 3.

That is, the horizontal signal lines 3 are arranged in a stacked manner on the substrate 11 and are led out through the leading wire posts 5, so as to facilitate subsequent electric connection between the horizontal signal lines 3 and the peripheral circuit. The vertical signal lines 4 are arranged perpendicular to the substrate 11, and thus are not required to be lead out through the leading wire posts 5. In some embodiments, the leading wire posts 5 may be directly in contact with the horizontal signal lines 3, so as to realize electric connection of the leading wire posts 5 and the horizontal signal lines 3. In some other embodiments, the leading wire posts 5 may be electrically connected to the horizontal signal lines 3 through conductive structures in the memory cells TC, which is described in detail subsequently.

Referring to FIG.4 to FIG. 22, in some embodiments, the memory cell TC may include a transistor T and a capacitor C arranged in the third direction Y. The horizontal signal lines 3 and the vertical signal lines 4 are connected to the transistor T. Exemplarily, in a Dynamic Random Access Memory (DRAM), the memory cell TC includes a transistor T and a capacitor C. In some other embodiments, the memory cell TC may include only the transistor T. For example, in a Static Random-Access Memory (SRAM), the memory cell is composed of six transistors T. For another example, a Capacitor-less Double Gate Quantum Well Single Transistor (1T DRAM), the memory cell is composed of one double gate transistor T.

The transistor includes a channel region 22 and a source/drain doped region 21 arranged in the third direction Y, and the source/drain doped region 21 is located at two sides of the channel region 22. One of the horizontal signal line 3 and the vertical signal line 4 is a bit line (BL), and the other one is a word line (WL). The bit line BL is connected to the source/drain doped region 21, and the word line WL is connected to the channel region 22. Exemplarily, the source/drain doped region 21 includes a first source/drain doped region 211 and a second source/drain doped region 212, the first source/drain doped region 211 is located between the BL and the channel region 22 and the second source/drain doped region 212 is located on a side of the channel region 22 deviating away from the first source/drain doped region 211.The first source/drain doped region 211 and the second source/drain doped region 212 may respectively serve as a source and a drain of the transistor T. In addition, the second source/drain doped region 21 may further include a light doped drain structure arranged between the channel region and the drain electrode.

A position relation among the leading wire post 5 and the memory cell TC and the horizontal signal line 3 is described below in detail.

In a case that the horizontal signal line 3 is BL and the vertical signal line 4 is WL, the position relation among the leading wire post 5 and the memory cell TC and the horizontal signal line 3 is described as follows.

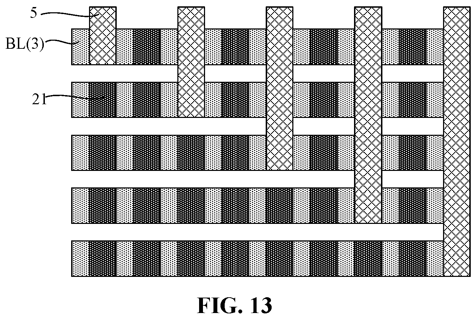

In a first example, referring to FIG. 4 and FIG. 12 to FIG. 17, a bottom surface of at least one leading wire post 5 is located in the source/drain doped region 21.That is, the orthographic projection of the leading wire post 5 on the surface of the substrate 11 is overlapped with the orthographic projection of the source/drain doped region 21 on the surface of the substrate 11, and the leading wire post 5 may be electrically in contact with the BL by utilizing a spatial position of the source/drain doped region 21. It is to be noted that FIG. 13, FIG. 15 and FIG. 17 are all schematic partially side view, and do not show the channel region, the vertical signal lines and the capacitors.

Specifically, at least one leading wire post 5 is in contact with the first source/drain doped region 211 of the corresponding layer. Since the first source/drain doped region 211 is closer to the BL than the second source/drain doped region 212, a distance between the leading wire post 5 and the BL may be shortened when the leading wire post 5 and the BL are electrically connected by utilizing the spatial position of the first source/drain doped region 211, thereby reducing resistance, and simplifies the production process. In a case that the leading wire post 5 and the BL are electrically connected by utilizing a spatial position of the second source/drain doped region 212, conducting processing may be performed on the channel region 22 and the first source/drain doped region 211, to reduce resistance of the channel region 22 and the first source/drain doped region 211.

In some embodiments, referring to FIG. 4 and FIG. 12 to FIG. 13, at least one leading wire post 5 penetrates through the source/drain doped region 21 in at least one memory cell TC. The orthographic projection of the leading wire post 5 on the surface of the substrate is at least partially overlapped with the orthographic projection of the memory cell TC, for example, the first source/drain doped region 211, on the surface of the substrate. Specifically, at least one leading wire post 5 penetrates through the source/drain doped region 21 of the corresponding layer. For example, the leading wire post 5 may penetrate through the first source/drain doped region 211 of the memory cell TC of the corresponding layer. In this case, the leading wire post 5 may be directly in contact with to the BL through the side wall.

In some other embodiments, referring to FIG. 14 to FIG. 15, a bottom surface of the leading wire post 5 is embedded into the source/drain doped region 21. That is, a bottom end of the leading wire post 5 is located in the source/drain doped region 21 and does not penetrate through the source/drain doped region 21 completely. In this case, the leading wire post 5 may not only be directly in contact with the BL, but also be electrically connected to the BL through the source/drain doped region 21.

In some other embodiments, referring to FIG. 16 to FIG. 17, a bottom surface of the leading wire post 5 is located on a top surface of the source/drain doped region 21. For example, the bottom surface of the leading wire post 5 is located on the top surface of the first source/drain doped region 211. In this case, the leading wire post 5 is not directly in contact with the BL, but is electrically connected to the BL through the source/drain doped region 21. In order to reduce the resistance of the source/drain doped region 21, conducting processing may be performed on the source/drain doped region 21. For example, a metal silicide is formed in the source/drain doped region 21 by adopting a metal silicification process. Alternately, heavy doping treatment is performed in the source/drain doped region 21.

It is to be noted that the leading wire post 5 in contact with the memory cell TC of the non-top layer may penetrate through the source/drain doped region 21 above the corresponding layer. The leading wire post 5 in contact with the memory cell TC of the top layer does not penetrate through other source/drain doped region 21 of a layer rather than the corresponding layer.

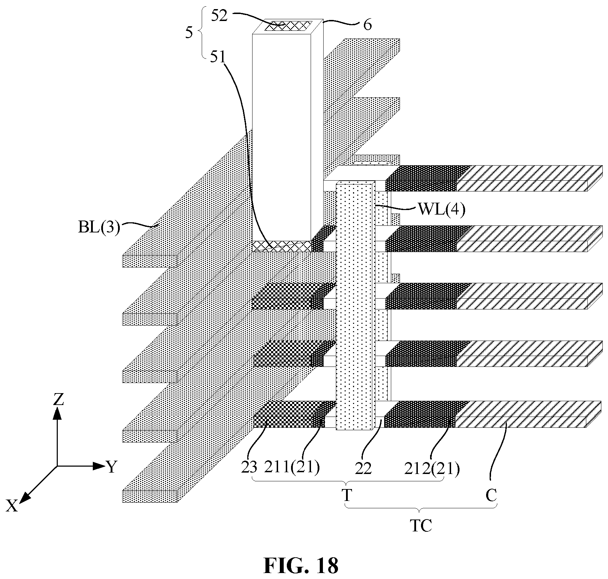

In a second example, referring to FIG. 18, the memory cell TC further includes a bit line contact area 23. The bit line contact area 23 connects the BL to the source/drain doped region 21. The bit line contact area 23 may reduce a contact resistance between the BL and the source/drain doped region 21. Exemplarily, the bit line contact area 23 may be a heavily doped polycrystalline silicon or metal silicide.

A bottom surface of at least one leading wire post 5 is located in the bit line contact area 23. That is, the leading wire post 5 may further be electrically connected to the BL by utilizing the bit line contact area 23. For example, at least one leading wire post 5 penetrates through the bit line contact area 23 in a memory cell TC. Alternatively, the at least one leading wire post 5 is embedded into the bit line contact area 23 of the corresponding layer. Alternately, the bottom surface of the at least one leading wire post 5 is in contact with a top surface of the bit line contact area 23 of the corresponding layer.

In a case that the horizontal signal line 3 is the WL and the vertical signal line 4 is the BL, a position relation between the leading wire post 5 and the memory cell TC and the horizontal signal line 3 is described as follows.

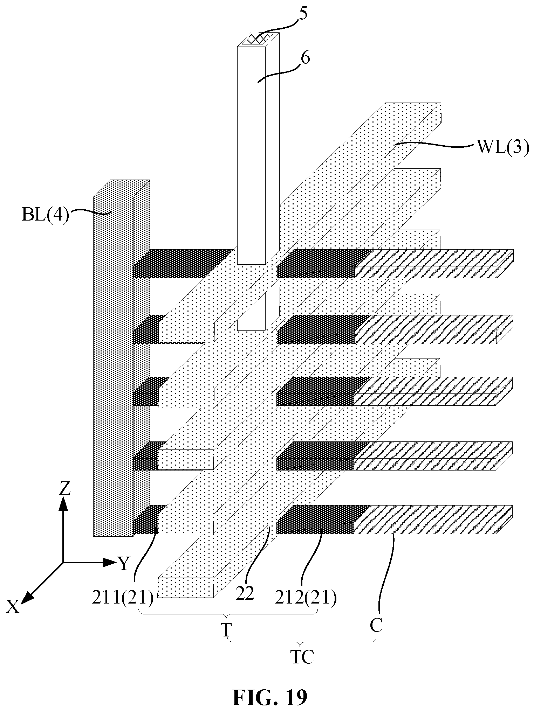

In a first example, referring to FIG. 19, a bottom surface of at least one leading wire post 5 is located in the channel region 22. That is, the orthographic projection of the leading wire post 5 on the surface of the substrate 11 is overlapped with the orthographic projection of the channel region 22 on the surface of the substrate 11, and the leading wire post 5 may be electrically connected to the word line WL by utilizing a spatial position of the channel region 22.

It is to be noted that there are various position relations between the word line WL and the channel region 22. For example, the word line WL may cover the entire channel region 22. Alternatively, the word line WL may be connected to a top surface and/or a bottom surface of the channel region 22.

A position relation between the leading wire post 5 and the word line WL is described below by taking a case that the word line WL at least covers the top surface of the channel region 22 as an example.

Referring to FIG. 19, in a case that the leading wire post 5 is in contact with the memory cell TC of the non-top layer, the leading wire post 5 is electrically connected to the word line WL on the memory cell TC of the corresponding layer and penetrates through the channel region 22 and the word line WL located above the corresponding layer. The orthographic projection of the leading wire post 5 on the surface of the substrate is at least partially overlapped with the orthographic projection of the channel region 22 in the memory cell TC on the surface of the substrate. It is to be noted that although the leading wire post 5 penetrates through the word line WL, the leading wire post 5 does not completely truncate the word line WL. For example, the leading wire post 5 penetrates through the center of the word line WL. The dielectric layer 6 exists between the leading wire post 5 and the word line WL above the corresponding layer, to prevent electrical connection between the leading wire post 5 and the word line WL above the corresponding layer.

In a case that the leading wire post 5 is in contact with the memory cell TC of the top layer, the leading wire post 5 may be electrically connected to the word line WL of the top layer without penetrating through any word line WL and the channel region 22.

Since the semiconductor structure at least includes two leading wire posts 5 in contact with the memory cells TC of different layers, at least one leading wire post 5 is in contact with the memory cell TC of the non-top layer. Therefore, the at least one leading wire post 5 penetrates through the channel region 22 in at least one memory cell TC.

It is to be noted that in a case that the word line WL does not cover the top surface of the channel region 22 but covers the bottom surface of the channel region 22, the leading wire post 5 in contact with the memory cell TC of the top layer at least penetrates through one channel region 22, so as to be connected to the WL on the bottom surface of the channel region 22.

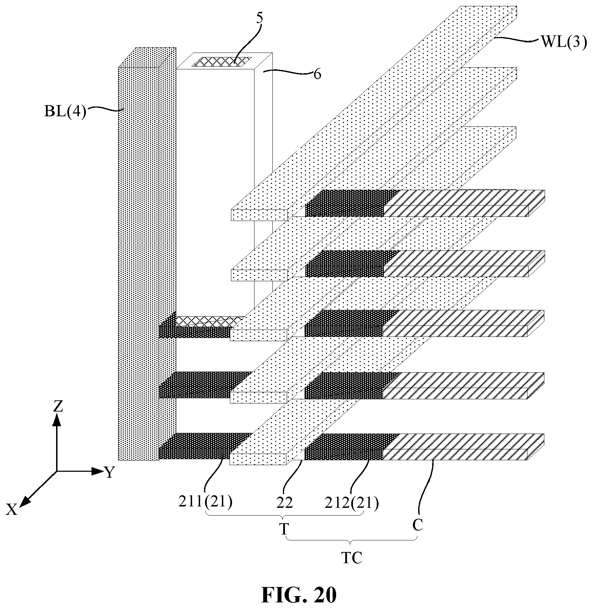

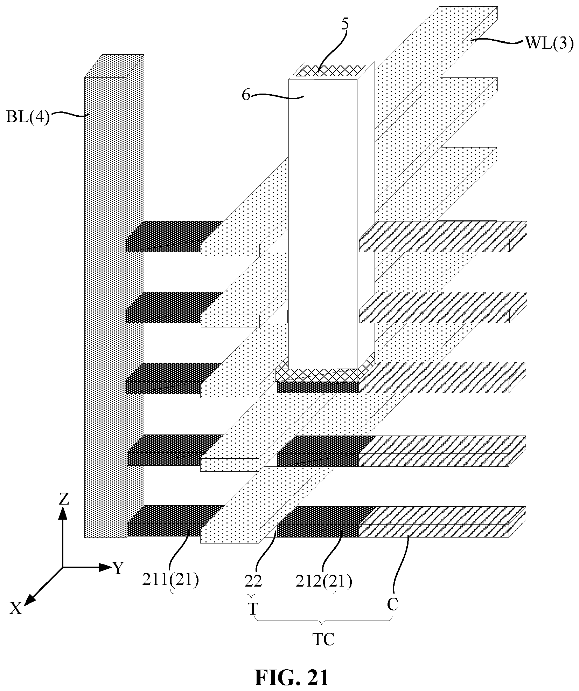

In a second example, referring to FIG. 20 to FIG. 21, the bottom surface of the at least one leading wire post 5 is located in the source/drain doped region 21, and a part of a side surface of the leading wire post 5 is connected to the WL of the corresponding layer. In addition, the word line WL further penetrates through the source/drain doped region 21 above the corresponding layer. That is, the leading wire post 5 may further be electrically connected to the word line WL by utilizing the source/drain doped region 21. Specifically, referring to FIG. 20, a bottom surface of the at least one leading wire post 5 is located in the first source/drain doped region 211 and a part of a side surface of the leading wire post 5 is connected to the WL of the corresponding layer, and the orthographic projection of the leading wire post 5 on the surface of the substrate is at least partially overlapped with the orthographic projection of the first source/drain doped region 211 in the memory cell TC on the surface of the substrate. Referring to FIG. 21, the bottom surface of the at least one leading wire post 5 is located in the second source/drain doped region 212 and a part of the side surface of the leading wire post 5 is connected to the word line WL of the corresponding layer, and the orthographic projection of the leading wire post 5 on the surface of the substrate is at least partially overlapped with the orthographic projection of the second source/drain doped region 212 in the memory cell TC on the surface of the substrate.

It is to be noted that the bottom surface of the leading wire post 5 is located in the source/drain doped region 21 but is electrically isolated from the source/drain doped region 21. For example, the bottom surface of the leading wire post 5 may form an isolation layer (not shown in FIG. 20 and FIG. 21). Alternatively, before the leading wire post 5 is formed, passivation treatment is performed on the surface of the source/drain doped region 21 of the corresponding layer.

The structure module is described below in detail.

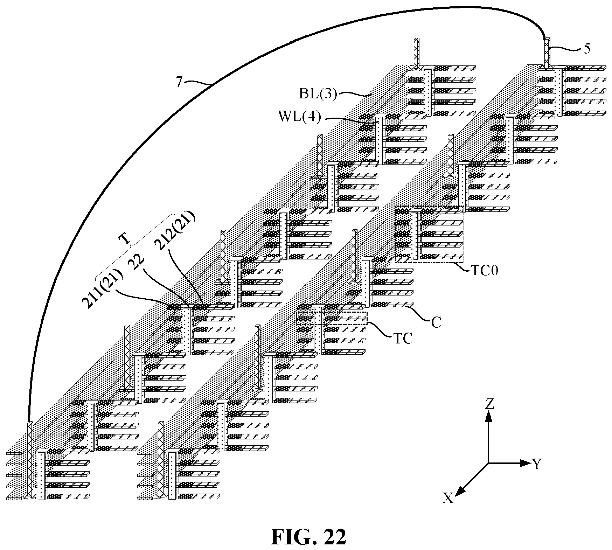

Referring to FIG. 22, there are a plurality of stacked structures, the plurality of horizontal signal lines 3 of the same stacked structure includes first to N-th horizontal signal lines successively arranged in the second direction Z, and N being a positive integer greater than 1.

Two stacked structures constitute a structure module. The structure module further includes a plurality of wires 7, and the wire 7 connects two leading wire posts 5 connected to different stacked structures. In other words, two leading wire posts 5 located in different stacked structures are connected by one wire 7, and a sum of sequence numbers of two horizontal signal lines 3 electrically connected to the two leading wire posts 5 is (N+1).

That is, the two horizontal signal lines 3 with the sum of sequence numbers being (N+1) may be electrically connected by the wire 7 through the leading wire posts 5. The two horizontal signal lines 3 electrically connected may form a horizontal signal line group. As a result of same potential, the two horizontal signal lines 3 of the horizontal signal line group may further be regarded as one horizontal signal line 3.

Exemplarily, the horizontal signal lines 3 include first to fifth horizontal signal lines, and the first horizontal signal line of a stacked structure is connected to the fifth horizontal signal line of another stacked structure. The second horizontal signal line of a stacked structure is connected to the fourth horizontal signal line of another stacked structure. The third horizontal signal line of a stacked structure is connected to the third horizontal signal line of another stacked structure. The first horizontal signal line is located in the top layer, and the fifth horizontal signal line is located in the bottom layer.

It is to be noted that since the leading wire post 5 penetrates through the memory cell TC, the penetrated memory cell TC no longer executes the storage function. Since the leading wire posts 5 are in contact with the memory cells TC of different layers, the numbers of available memory cells TC of different layers in the semiconductor structure are different. For example, there are totally five layers of memory cells TC. The first layer as the top layer is lack of five memory cells TC. The second layer is lack of four memory cells TC. The third layer is lack of three memory cells TC. The fourth layer is lack of two memory cells TC. The fifth layer, as the bottom layer, is lack of one memory cell TC. Under the action of the wire 7, the numbers of the memory cells TC connected to different horizontal signal line groups are identical.

In addition, since the leading wire posts 5 in contact with the memory cells TC of different layers have different lengths, different resistances are generated. Based on an RC delayed effect, delay times of different memory cells TC are different. Under the action of the wire 7, the leading wire posts 5 in pairs form a group, and the total lengths of the leading wire posts 5 in each group are substantially identical, thereby unifying the delay time, so as to improve the performance of the semiconductor structure.

In addition, the contact areas between the memory cells TC of different layers and the leading wire post 5 may be kept consistent, so as to obtain consistent contact resistance, thereby preventing generation of different delay times. For example, the contact areas between the memory cells TC of different layers and the leading wire post 5 all are 0.036-0.054 µm².

In some embodiments, two leading wire posts 5 connected by the wire 7 are arranged directly opposite, and an extension direction of the wire 7 is perpendicular to the first direction X, to shorten the distance between the two leading wire posts 5, and reduce the length of the wire. Since the length of the wire is reduced, the resistance is reduced, the power consumption is reduced, and the delay time is shortened. In some other embodiments, referring to FIG. 22, the two leading wire posts 5 connected by the wire 7 may be staggered to each other.

In the same structure module, the transistor T of one stacked structure is arranged facing to the transistor T of the other stacked structure. That is, the capacitor C of a stacked structure has two opposite sides arranged in the third direction Y. A side of the capacitor facing the other stacked structure is an inner side, and a side of the capacitor opposite to the other stacked structure is an outer side. The transistors T are arranged facing to each other, indicating that the two transistors T both are arranged on the inner sides of the stacked structures where the transistors are arranged, to shorten the distance between the two transistors T, and further shorten the distance between the two leading wire posts 5, so as to reduce the lengths of the wire 7.

As shown in FIG. 22, in some other embodiments, in the same structure module, the transistor T of a stacked structure is arranged in a same direction as the transistor T of the other stacked structure. Alternatively, in the same structure module, the transistor T of a stacked structure is arranged opposite to the transistor T of the other stacked structure. The transistors T are arranged in a same direction, indicating that the transistor T of a stacked structure is located on the inner side of the capacitor C and the transistor T of the other stacked structure is located on the outer side of the capacitor C. The transistors T are arranged oppositely, indicating that the transistors T of the two stacked structures both are arranged on the outer side of the capacitor C.

In conclusion, in the embodiments of the disclosure, at least two leading wire posts 5 are integrated, from the staircase, into an area where the memory cells TC are arranged, thereby improving a utilization ratio of the surface area of the substrate 11. In a case that all the leading wire posts 5 are arranged in the area where the memory cells TC are arranged, it is unnecessary to arrange the separate staircase, thereby improving the integration level of the semiconductor structure, and increasing the number of the memory cells TC.

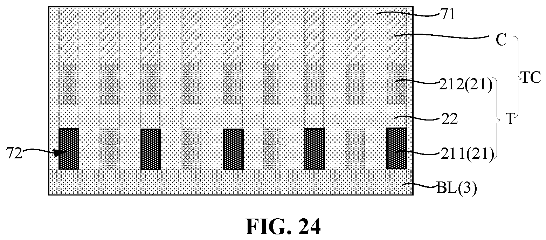

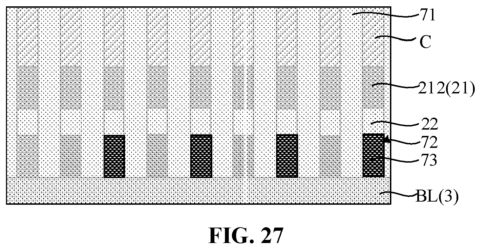

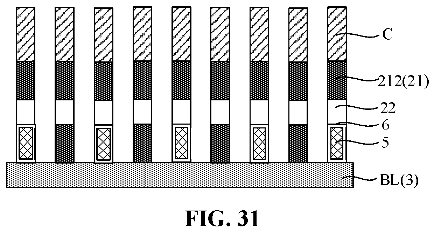

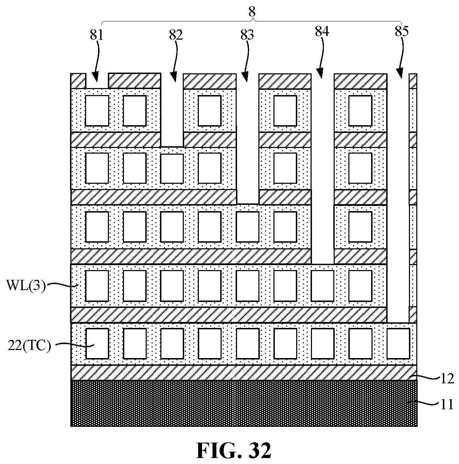

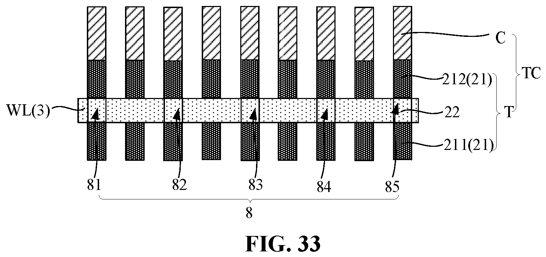

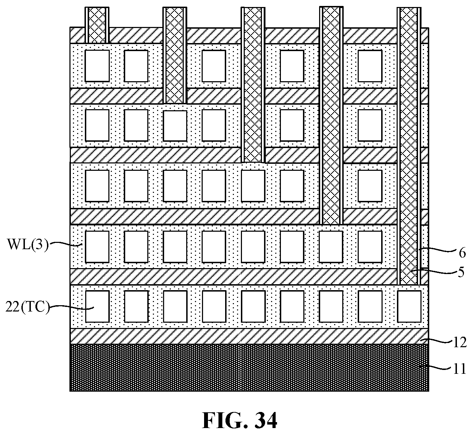

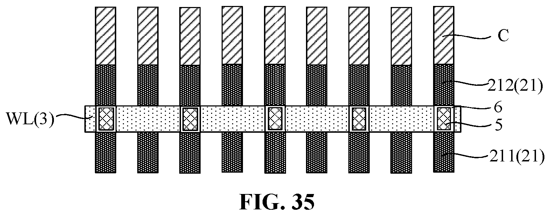

As shown in FIG. 23 to FIG. 35, another embodiment of the disclosure further provides a method for manufacturing a semiconductor structure. The method may be used for manufacturing the semiconductor structure provided by the aforementioned embodiment, and regarding the detailed description about the semiconductor structure, reference may be made to the aforementioned embodiment. It is to be noted that in order to conveniently describe and clearly illustrate operations of the method for manufacturing the semiconductor structure, FIG. 23 to FIG. 35 all are schematic partially structural diagrams of semiconductor structure. FIG. 23, FIG. 25, FIG. 26 and FIG. 28 to FIG. 30 are schematic partial side view, in which the channel regions, the vertical signal lines and the capacitors are not shown. FIG. 24, FIG. 27 and FIG. 31 are partial side views in which an insulating layer 12 is not shown. FIG. 32 and FIG. 34 are sectional views in the first direction X and FIG. 33 and FIG. 34 are partial top views, in which the insulating layer 12 is not shown.

Referring to FIG. 23, the substrate 11 is provided. A stacked structure is formed on the substrate 11, the stacked structure includes a plurality of memory cell groups TC0 (referring to FIG. 1) arranged in a first direction X, each of the memory cell groups TC0 includes multiple layers of memory cells TC arranged in the second direction Z. The plurality of memory cells TC of the same memory cell group TC0 include the first memory cell to the N-th memory cell successively arranged. The first memory cell is located in the top layer, and the N-th memory cell is located in the bottom layer.

Exemplarily, the memory cell TC may include a transistor T and a capacitor C.

Specifically, the operation that the transistor T is formed may include operations as follows. Multiple active layers are arranged at an interval, and each of the active layers includes a plurality of active structures. Doping treatment is performed on the active structure, to form a source/drain doped region 21 and a channel region 22. A gate dielectric layer is formed on a surface of the channel region 22. That is, the memory cell TC includes a channel region 22 and a source/drain doped region 21 arranged in the third direction Y. The source/drain doped region 21 is located on two sides of the channel region 22. The third direction Y is parallel to the surface of the substrate 11.

In addition, an insulating layer 12 is arranged between the transistors T of adjacent layers, so as to isolate the adjacent transistors T.

The operation that the capacitor C is formed may include an operation. A capacitor supporting layer and a capacitor hole located in the capacitor supporting layer are formed. A lower electrode is formed on an inner wall of the capacitor hole. A capacitor dielectric layer is formed on a surface of the lower electrode, and an upper electrode is formed on the surface of the capacitor dielectric layer. The lower electrode, the capacitor dielectric layer and the upper electrode form the capacitor C.

The method further includes operations as follows. A plurality of horizontal signal lines 3 and a plurality of vertical signal lines 4 (referring to FIG. 4) are formed. The plurality of horizontal signal lines 3 are arranged in the second direction Z and extend along the first direction X. Each of the horizontal signal lines 3 is connected to the memory cells TC of one layer. The vertical signal lines 4 extend along the second direction Z and are connected to the multiple layers of memory cells TC of the same memory cell group TC0. The first direction X is parallel to the surface of the substrate 11, and the second direction Z is perpendicular to the surface of the substrate 11.

One of the horizontal signal line 4 and the vertical signal line 3 is a bit line (BL), and the other one is a word line (WL). The bit line BL is connected to the source/drain doped region 21, and the word line WL, as a gate, is connected to the channel region 22.

A method for forming the vertical signal line 4 may include operations as follows. An isolation structure is formed, and the isolation structure is etched to form a filling hole in the isolation structure. The filling hole extends in the second direction Z. A conductive material is deposited in the filling hole, to form the vertical signal line 4.

The operation that the horizontal signal line 3 is formed may include operations as follows. A conductive material is deposited on the surface of the active structure, to enable the conductive material to wrap the active structure of the same layer. Hereafter, an isolation structure is formed between the adjacent horizontal signal lines 3.

Referring to FIG. 23 to FIG. 35, a plurality of leading wire posts 5 are formed, where at least two leading wire posts 5 are respectively in contact with different layers of memory cells TC in different memory cell groups TC0.

The operation that the leading wire post 5 is formed is described below in detail.

In a case that the horizontal signal lines 3 are bit lines BL and the vertical signal lines 4 are word lines WL, the operation that the leading wire post 5 is formed include the following operations.

First, it is to be noted that the plurality of source/drain doped regions 21 of the same memory cell group TC0 include the first layer of source/drain doped region to the N-th layer of source/drain doped region which are successively arranged, N being a positive integer. The first layer source/drain doped region is located in the top layer, and the N-th layer of source/drain doped region is located in the bottom layer.

Referring to FIG. 23 to FIG. 24, a mask layer 71 is formed, and the mask layer 71 has N openings 72, N being a positive integer. The openings 72 are located above the source/drain doped region 21. For example, the openings are located above the first source/drain doped region 211. Exemplarily, the mask layer 71 may be a photoresist layer, and the photoresist layer is photo-etched to form the openings 72. Alternatively, the mask layer 71 may further be a hard mask layer and a photoresist layer arranged in an overlapped manner, and after the photoresist layer is photo-etched, the hard mask layer is then etched, to form the openings 72.

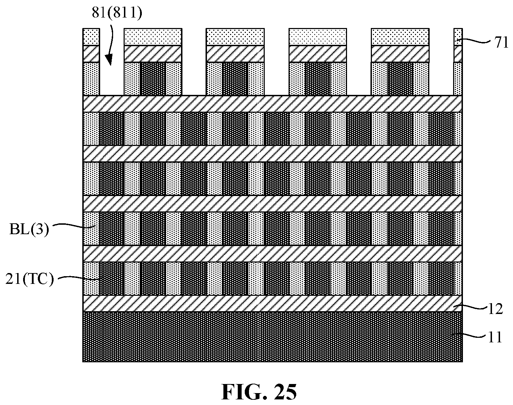

Referring to FIG. 25, the first memory cell is etched along the openings 72 to form a plurality of first sub-through holes 811. One of the first sub-through holes 811 is taken as a first through hole 81. Specifically, the source/drain doped region 21 is etched along the openings 72. In addition, before the first memory cell is etched, the insulating layer 12 located above the first memory cell is etched.

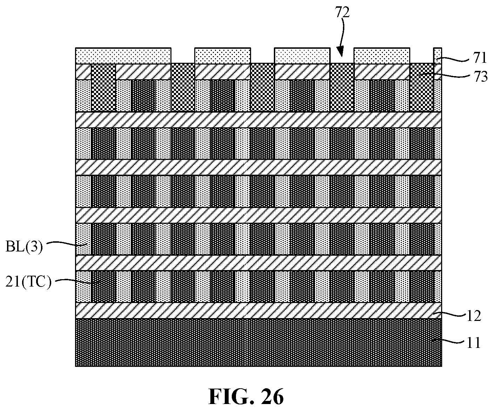

Referring to FIG. 26 to FIG. 27, a sacrificial layer 73 filling the first sub-through holes 8 is formed. Exemplarily, a low dielectric constant material such as silicon oxide is deposited in the first sub-through holes 8 to serve as the sacrificial layer 73.

Continuously referring to FIG. 26 to FIG. 27, the mask layer 71 is patterned to enable the mask layer 71 to have the (N-1) openings 72. Specifically, the photoresist layer may be spin-coated again, and the photoresist layer is photo-etched to form the openings 72.

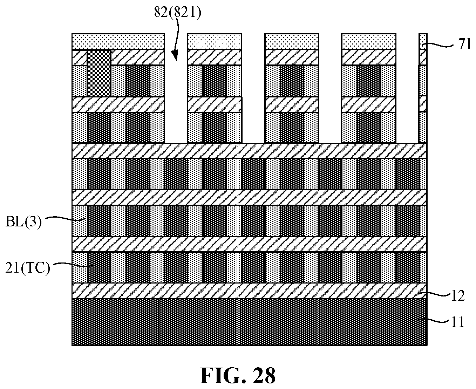

Referring to FIG. 28, the sacrificial layer 73 and the second memory cell are etched along the openings 72 to form (N-1) second sub-through holes 821. One of the second sub-through holes 821 serves as a second through hole 82. After the sacrificial layer 73 is etched, the insulating layer 72 located on the second memory cell is etched.

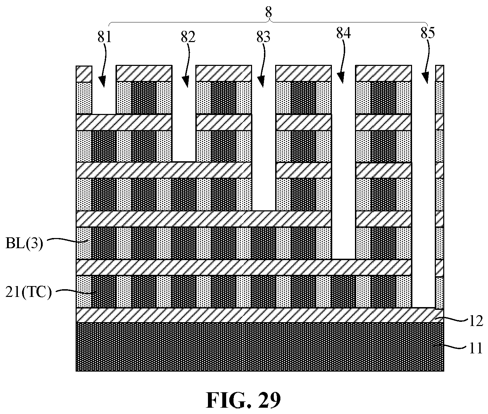

Referring to FIG. 29, the operations of forming the sacrificial layer 73, patterning the mask layer 71 and etching are repeated till the N-th memory cell is penetrated, that is, the N-th source/drain doped region is penetrated. In some other embodiments, the operations of forming the sacrificial layer, patterning the mask layer 71 and etching are repeated till the (N-1)-th memory cell is penetrated, and the N-th memory cell is exposed. Alternatively, the (N-1)-th memory cell is penetrated, and the N-th memory cell of partial thickness is removed.

At this point, based on FIG. 23 to FIG. 29, the through hole 8 may be formed, and the through hole 8 includes the first through hole to the N-th through hole. Exemplarily, referring to FIG. 29, the first through hole 81, the second through hole 82, the third through hole 83, the fourth through hole 84 and the fifth through hole 85 may be formed. In some embodiments, the first through hole 81 may penetrate through the first layer of source/drain doped region, and the N-th through hole may penetrate through the first layer of source/drain doped region to the N-th layer of source/drain doped region 21. In some other embodiments, the first layer of source/drain doped region 21 is exposed in the first through hole 8, and the N-th through hole penetrates through the first layer of source/drain doped region to the (N-1)-th layer of source/drain doped region 21, and exposes the N-th layer of source/drain doped region 21. In some other embodiments, the first layer of source/drain doped region 21 is embedded onto the bottom of the first through hole 8, the N-th through hole penetrates through the first layer of source/drain doped region to the (N-1)-th layer of source/drain doped region, and the N-th layer of source/drain doped region is embedded onto the bottom of the N-th through hole. It is to be noted that depths of the first through hole 81, the second through hole 82, the third through hole 83, the fourth through hole 84 and the fifth through hole 85 arranged successively increase progressively in the first direction X. In other embodiments, depths of the first through hole 81, the second through hole 82, the third through hole 83, the fourth through hole 84 and the fifth through hole 85 arranged successively may not increase or decrease progressively in the first direction X, but the depths of the through holes are alternated, so as to avoid too large parasitic capacitance between the leading wire posts 5 with large depths among the subsequently formed leading wire posts 5.

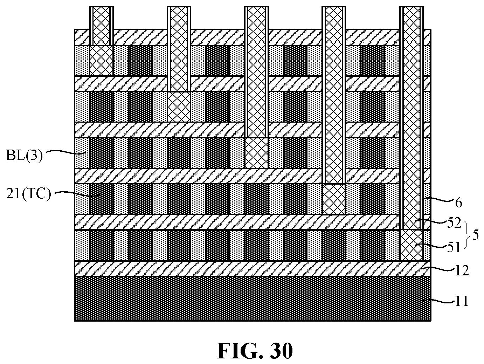

Referring to FIG. 30 to FIG. 31, the dielectric layer 6 covering a side wall of the through hole 8 is formed, and the leading wire post 5 filling the through hole 8 is formed, and the leading wire post 5 contacts with the corresponding source/drain doped region 21.

Specifically, in a case that the N-th through hole penetrates the N-th layer of source/drain doped region 21, or the N-th through hole penetrates the (N-1)-th layer of source/drain doped region 21 and the bottom of N-th through hole is embedded into the N-th layer of source/drain doped region 21, the operation that the dielectric layer 6 and the leading wire post 5 are formed may include the following operations.

The contact portion 51 is formed in the bottom of the through hole 8, and the contact portion 51 is in contact with the memory cell TC of the corresponding layer. After the contact portion 51 is formed, the dielectric layer 6 is formed on the side wall of the through hole 8. Exemplarily, an initial dielectric layer is formed on the side wall of the through hole 8 and a surface of the contact portion 51 through a chemical vapor deposition process. The initial dielectric layer on the surface of the contact portion 51 is removed, and the initial dielectric layer located on the side wall of the through hole 8 is taken as the dielectric layer 6. After the dielectric layer 6 is formed, an extension portion 52 filling the through hole 8 is formed. The extension portion 52 and the contact portion 51 form the leading wire post 5.

In a case that the N-th through hole 8 penetrates the (N-1)-th layer of source/drain doped region, and the N-th layer of source/drain doped region is exposed, the operation that the dielectric layer 6 and the leading wire post 5 are formed may include operations as follows. The dielectric layer 6 is formed on an inner wall of the through hole 8, and after the dielectric layer 6 is formed, the leading wire post 5 filling the through hole 8 is then formed. In this case, a metal silicide may be formed in the source/drain doped region 21 of the corresponding layer by adopting a metal silicification process, to reduce the contact resistance. Specifically, a metal layer is deposited on the inner wall of the through hole 8, and thermal treatment is performed so that the metal layer is reacted with the source/drain doped region 21. Hereafter, an unreacted metal layer is removed, and the unreacted metal layer is mainly located on the side wall of the through hole 8. Then, the dielectric layer 6 and the leading wire post 5 are formed.

In a case that the horizontal signal lines 3 are the bit lines BL and the vertical signal lines 4 are word lines WL, the operation that the leading wire post 5 is formed include the following operations.

First, it is to be noted that the plurality of channel regions 22 of the same memory cell group TC0 include the first channel region to the N-th channel region successively arranged, N being a positive integer. The first channel region is located in the top layer, and the N-th channel region is located in the bottom layer.

Referring to FIG. 32 to FIG. 33, the through hole 8 is formed, the through hole 8 includes the first through hole 81 to the N-th through hole. The word line WL connected to the first channel region is exposed in the first through hole 8, and the N-th through hole 8 penetrates through the first channel region 22 to the (N-1)-th channel region and exposes the WL connected to the N-th channel region. The operation that the through hole 8 is formed may refer to aforementioned detailed description.

Referring to FIG. 34 to FIG. 35, a dielectric layer 6 covering the side wall of the through hole 8 is formed. Specifically, an initial dielectric layer is formed on an inside wall of the through hole 8. The initial dielectric layer located on the bottom wall of the through hole 8 is removed to expose the word line WL of the corresponding layer, and the initial dielectric layer located on the side wall of the through hole 8 is taken as the dielectric layer 6.

Continuously referring to FIG. 34 to FIG. 35, the leading wire post 5 filling the through hole 8 is formed, the leading wire post 5 is in contact with the corresponding word line WL. Exemplarily, metals such as copper, aluminum, titanium or tungsten are deposited in the through hole 8 as the leading wire post 5.

It is to be noted that the abovementioned method for forming the leading wire post 5 is merely exemplary described but is not limited thereto. The method for forming the leading wire post 5 may be adjusted according to a specific structure of the leading wire post 5.

In conclusion, in the embodiments of the disclosure, the memory cell TC is etched to form the through hole 8, and the dielectric layer and the leading wire post 5 filling the through hole 8 is formed. Therefore, the leading wire post 5 may be electrically connected to the memory cell TC directly by utilizing a spatial position of the memory cell TC, to reduce the number of stairs without forming the independent staircase, thereby improving the integration level of the semiconductor structure.

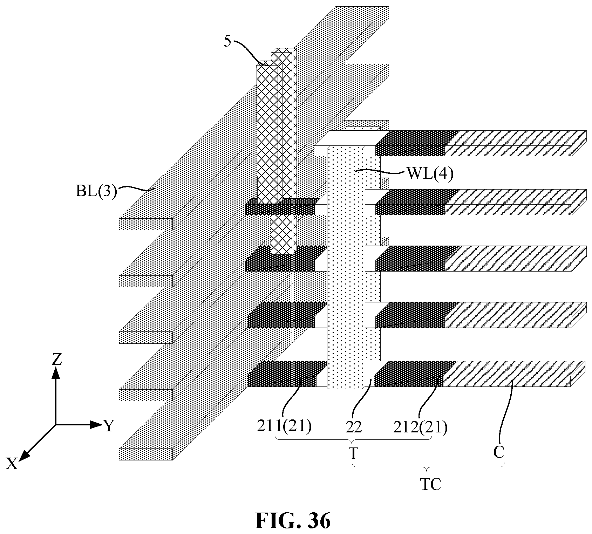

Referring to FIG. 36 to FIG. 38, another embodiment of the disclosure further provides a semiconductor structure. The semiconductor structure is substantially same with the semiconductor structure in the aforementioned embodiments. The main difference lies in that at least two leading wire posts 5 of this semiconductor structure are in contact with different memory cells TC in the same memory cell group TC0. Regarding the parts of the semiconductor structure same as or similar to the semiconductor structure in the aforementioned embodiments, reference can be made to detailed description in the aforementioned embodiments, which is not described in detail herein.

The semiconductor includes a substrate 11 (referring to FIG. 34) on which the a stacked structure is provided. The stacked structure includes a plurality of memory cell groups TC0 arranged in a first direction X, and each of the memory cell groups TC0 includes multiple layers of memory cells TC arranged in a second direction Z. The semiconductor further includes a plurality of leading wire posts 5. At least two leading wire posts 5 are in contact with different memory cells TC in the same memory cell group TC0.

Compared with a case that different leading wire posts 5 are located in different memory cell groups TC0, at least two leading wire posts 5 may utilize the spatial position of the same memory cell group TC0, thereby improving the spatial utilization ratio of the same memory cell group TC0 and further increasing the number of the available memory cells TC. For example, in a case that two leading wire posts 5 are respectively connected to the memory cell TC of the top layer and the memory cell TC of the secondary top layer, when the memory cell TC of the top layer and the memory cell TC of the secondary top layer are located in different memory cell group TC0, three memory cells TC are invalid. When the memory cell TC of the top layer and the memory cell TC of the secondary top layer are located in the same memory cell group TC0, two memory cells TC are invalid.

It is to be noted that in the same semiconductor structure, the abovementioned two solutions may further be combined. For example, the semiconductor structure includes at least four leading wire posts 5. At least two leading wire posts 5 are respectively connected to different layers of memory cells TC in different memory cell groups TC0, and at least two leading wire posts 5 are respectively connected to different layers of memory cells TC in the same memory cell group TC0.

Continuously referring to FIG. 36 to FIG. 38, at least two leading wire posts 5 in contact with different memory cells TC in the same memory cell group TC0 are arranged along the first direction X, to unify a contact position between the leading wire posts 5 and the memory cells TC, thereby simplifying the connection process.

In some embodiments, the stacked structure further includes a plurality of horizontal signal lines 3 and a plurality of vertical signal lines 4. The plurality of horizontal signal lines 3 are arranged in the second direction Z and extend along the first direction X, and are connected to one layer of the memory cells TC. The vertical signal lines 4 extend along the second direction Z and are connected to the multiple layers of memory cells TC of the same memory cell group TC0. The leading wire posts 5 are electrically connected to the horizontal signal lines 3.

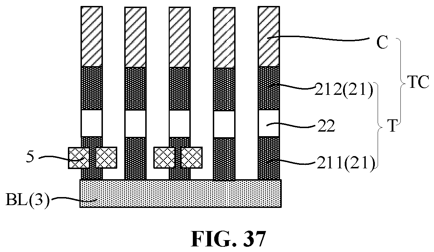

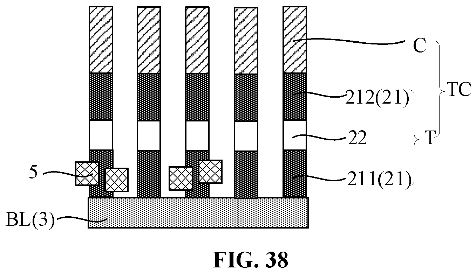

In some embodiments, the leading wire posts 5 in contact with different memory cells TC in the same memory cell group TC0 are lined up along the first direction X. That is, the leading wire posts 5 are substantially aligned in the first direction X. Therefore, the distances of the plurality of leading wire posts 5 in relative to the horizontal signal lines 3 are substantially identical, thereby unifying the contact resistance between the plurality of leading wire posts 5 and the horizontal signal lines 3. In addition, the process is simplified and the uniformity of the semiconductor structure is improved. For example, referring to FIG. 37, two ends of the plurality of leading wire posts 5 are aligned in the first direction X, thereby simplifying the process. Referring to FIG. 38, two ends of the plurality of leading wire posts 5 are slightly staggered in the first direction X, to reduce the area of a directly facing region, thereby reducing parasitic capacitance.

In conclusion, in the embodiments of the disclosure, at least two leading wire posts 5 are integrated, from the staircase, into an area where the memory cells TC are arranged, thereby improving a utilization ratio of the surface area of the substrate 11. In addition, at least two leading wire posts 5 are in contact with different layers of memory cells C in same memory cell group TC0, indicating that at least two leading wire posts 5 may utilize the spatial space of the same memory cell group TC0, to decrease the number of the invalid memory cells TC, thereby improving the integration level of the semiconductor structure.

The embodiments of the disclosure further provide a memory chip, including the semiconductor structure provided by the aforementioned embodiments.

The memory chip is a memory part for storing programs and various data information. Exemplarily, the memory chip may be a random access memory chip or a read-only memory chip. For example, the random access memory chip may include a Dynamic Random Access Memory (DRAM) or a Static Random Access Memory (SRAM). Since the integration level of the aforementioned semiconductor structure is high, it contributes to realizing microminiaturization of the memory chip.

The embodiments of the disclosure further provide an electronic device, including the memory chip provided by the aforementioned embodiments.

Exemplarily, the electronic device may be a device such as a television, a computer, a mobile phone or a tablet computer. The electronic device may include a circuit board and a package structure, and the memory chip may be welded to the circuit board and is protected by the package structure. In addition, the electronic device may further include a power supply for providing a working voltage to the memory chip.

In the description of the specification, the description with reference to the terms "some embodiments", "exemplarily", and the like means that specific features, structures, materials, or features described in connection with the embodiments or examples are included in at least one embodiment or example of the disclosure. In the description, schematic expressions of the terms do not have to mean same embodiments or exemplary embodiments. Furthermore, specific features, structures, materials or characteristics described can be combined in any one or more embodiments or exemplary embodiments in proper manners. In addition, under a condition without mutual contradiction, those skilled in the art can integrate or combine different embodiments or examples with features of different embodiments or examples described in the description.

Although the embodiments of the disclosure have been shown and described above, it can be understood that the above embodiments are exemplary and cannot be construed as limitation to the disclosure. Those of ordinary skill in the art can make changes, modification, replacement and transformation on the embodiments within the scope of the present disclosure.

## Claims

1. A semiconductor structure, comprising:
a substrate (11) on which at least one stacked structure is provided, the stacked structure comprising a plurality of memory cell groups (TCO) arranged in a first direction, each of the memory cell groups (TCO) comprising multiple layers of memory cells (TC) arranged in a second direction; and
the first direction is parallel to a surface of the substrate (11), and the second direction is perpendicular to the surface of the substrate (11);
the stacked structure further comprises a plurality of horizontal signal lines (3) and a plurality of vertical signal lines (4), wherein the plurality of horizontal signal lines (3) are arranged in the second direction and extend along the first direction, and each of the horizontal signal lines (3) is connected to one layer of memory cells (TC), and the vertical signal lines (4) extend along the second direction and are connected to multiple layers of memory cells (TC) in a same memory cell group (TCO); **characterized by**
a plurality of leading wire posts (5), wherein at least two leading wire posts (5) of the plurality of leading wire posts (5) respectively are in contact with different layers of memory cells (TC) in different memory cell groups (TCO), the at least two leading wire posts utilize the space of different memory cell groups (TCO); and
the leading wire posts (5) are electrically connected to the horizontal signal lines (3).

2. The semiconductor structure according to claim 1, wherein
the leading wire posts (5) are arranged along the first direction.

3. The semiconductor structure according to claim 1, wherein
all the memory cells (TC) in a same memory cell group (TCO) are in contact with at most one leading wire post (5) of the plurality of leading wire posts (5).

4. The semiconductor structure according to claim 1, wherein
the number of the plurality of leading wire posts (5) is equal to or greater than the number of layers of the memory cells (TC), and each layer of memory cells (TC) at least comprises one memory cell (TC) in contact with a corresponding leading wire post (5).

5. The semiconductor structure according to claim 1, wherein
the number of leading wire posts (5) in contact with one of the memory cell groups (TCO) is less than the number of layers of the memory cells (TC) in the one memory cell group (TCO).

6. The semiconductor structure according to claim 1, wherein
each of the memory cells (TC) comprises a channel region (22) and a source/drain doped region (21) arranged in a third direction, the source/drain doped region (21) is arranged at two sides of the channel region (22), and the third direction is parallel to the surface of the substrate (11).

7. The semiconductor structure according to claim 6, wherein
each of the plurality of horizontal signal lines (3) is a bit line, and each of the plurality of vertical signal lines (4) is a word line,
the bit line is connected to the source/drain doped region (21), and the word line is connected to the channel region (22); and
at least one of the plurality of leading wire posts (5) penetrates through the source/drain doped region (21) in at least one of the memory cells (TC), wherein
the source/drain doped region (21) comprise a first source/drain doped region (211) and a second source/drain doped region (212), the first source/drain doped region (211) is located between the bit line and the channel region (22), and the second source/drain doped region (212) is located at a side of the channel region (22) opposite to the first source/drain doped region (211); and
the leading wire post (5) penetrates through the first source/drain doped region (211).

8. The semiconductor structure according to claim 6, wherein
each of the plurality of horizontal signal lines (3) is a word line, and each of the plurality of vertical signal lines (4) is a bit line,
the bit line is connected to the source/drain doped region (21), and the word line is connected to the channel region (22); and
at least one of the plurality of leading wire posts (5) penetrates through the channel region (22) in at least one of the memory cells (TC).

9. The semiconductor structure according to claim 6, wherein the memory cell (TC) further comprises a bit line contact area (23), the bit line contact area (23) connecting the bit line to the source/drain doped region (21),
wherein at least one of the plurality of leading wire posts (5) penetrates through the bit line contact area (23) in one of the memory cells (TC).

10. The semiconductor structure according to claim 9, wherein
the numbers of memory cells (TC) which the at least two leading wire posts (5) penetrate through are different from each other.

11. The semiconductor structure according to claim 1, wherein
two adjacent leading wire posts (5) of the plurality of leading wire posts (5) are at least spaced by one of the plurality of memory cell groups (TCO), wherein
the number of memory cells (TC) between the two adjacent leading wire posts (5) is fixed, or, the area of a directly facing region between the two adjacent leading wire posts (5) is directly proportional to the number of memory cell groups (TCO) between the two adjacent leading wire posts (5).

12. The semiconductor structure according to claim 1, wherein
the number of stacked structures is greater than one, the plurality of horizontal signal lines (3) of a same stacked structure comprises a first horizontal signal line to N-th horizontal signal line successively arranged in the second direction, N being a positive integer greater than 1; and
two stacked structures of the stacked structures further comprise a plurality of wires (7), each wire (7) connects two leading wire posts (5), which are in contact with different stacked structures of the stacked structures, of the plurality of leading wire posts (5), and a sum of sequence numbers of the two horizontal signal lines (3) electrically connected to the two leading wire posts (5) being N+1.

13. The semiconductor structure according to claim 1, wherein the at least two leading wire posts (5) of the plurality of leading wire posts (5) are in contact with different memory cells (TC) in a same memory cell group (TCO).

14. A method for manufacturing a semiconductor structure, comprising:
providing a substrate,
forming at least one stacked structure on the substrate, the stacked structure comprising a plurality of memory cell groups arranged in a first direction, each of the memory cell groups comprising multiple layers of memory cells arranged in a second direction; and
the first direction is parallel to a surface of the substrate (11), and the second direction is perpendicular to the surface of the substrate (11);
the stacked structure further comprises a plurality of horizontal signal lines (3) and a plurality of vertical signal lines (4), wherein the plurality of horizontal signal lines (3) are arranged in the second direction and extend along the first direction, and each of the horizontal signal lines (3) is connected to one layer of memory cells (TC), and the vertical signal lines (4) extend along the second direction and are connected to multiple layers of memory cells (TC) in a same memory cell group (TCO); **characterized by**
a plurality of leading wire posts (5), wherein at least two leading wire posts (5) of the plurality of leading wire posts (5) respectively are in contact with different layers of memory cells (TC) in different memory cell groups (TCO), the at least two leading wire posts utilize the space of different memory cell groups (TCO); and
the leading wire posts (5) are electrically connected to the horizontal signal lines (3).

## Patentansprüche

1. Halbleiterstruktur, umfassend:
ein Substrat (11), auf dem mindestens eine gestapelte Struktur vorgesehen ist, wobei die gestapelte Struktur eine Vielzahl von Speicherzellengruppen (TCO) umfasst, die in einer ersten Richtung angeordnet sind, wobei jede der Speicherzellengruppen (TCO) mehrere Schichten von Speicherzellen (TC) umfasst, die in einer zweiten Richtung angeordnet sind; und
die erste Richtung parallel zu einer Oberfläche des Substrats (11) verläuft und die zweite Richtung senkrecht zu der Oberfläche des Substrats (11) steht;
die gestapelte Struktur ferner eine Vielzahl horizontaler Signalleitungen (3) und eine Vielzahl vertikaler Signalleitungen (4) umfasst, wobei die Vielzahl horizontaler Signalleitungen (3) in der zweiten Richtung angeordnet ist und sich entlang der ersten Richtung erstreckt, und jede der horizontalen Signalleitungen (3) mit einer Schicht von Speicherzellen (TC) verbunden ist, und wobei die vertikalen Signalleitungen (4) sich entlang der zweiten Richtung erstrecken und mit mehreren Schichten von Speicherzellen (TC) in derselben Speicherzellengruppe (TCO) verbunden sind;
**gekennzeichnet durch**
eine Vielzahl von führenden Drahtpfosten (5), wobei mindestens zwei führende Drahtpfosten (5) der Vielzahl von führenden Drahtpfosten (5) jeweils mit unterschiedlichen Schichten von Speicherzellen (TC) in unterschiedlichen Speicherzellengruppen (TCO) in Kontakt stehen, wobei die mindestens zwei führenden Drahtpfosten den Raum unterschiedlicher Speicherzellengruppen (TCO) nutzen; und
die führenden Drahtpfosten (5) elektrisch mit den horizontalen Signalleitungen (3) verbunden sind.

2. Halbleiterstruktur nach Anspruch 1, wobei
die führenden Drahtpfosten (5) entlang der ersten Richtung angeordnet sind.

3. Halbleiterstruktur nach Anspruch 1, wobei
alle Speicherzellen (TC) in derselben Speicherzellengruppe (TCO) mit höchstens einem führenden Drahtpfosten (5) der mehreren führenden Drahtpfosten (5) in Kontakt stehen.

4. Halbleiterstruktur nach Anspruch 1, wobei
die Anzahl der mehreren führenden Drahtpfosten (5) gleich oder größer als die Anzahl der Schichten der Speicherzellen (TC) ist und jede Schicht von Speicherzellen (TC) mindestens eine Speicherzelle (TC) umfasst, die mit einem entsprechenden führenden Drahtpfosten (5) in Kontakt steht.

5. Halbleiterstruktur nach Anspruch 1, wobei
die Anzahl der führenden Drahtpfosten (5), die mit einer der Speicherzellengruppen (TCO) in Kontakt stehen, kleiner ist als die Anzahl der Schichten der Speicherzellen (TC) in der einen Speicherzellengruppe (TCO).

6. Halbleiterstruktur nach Anspruch 1, wobei
jede der Speicherzellen (TC) einen Kanalbereich (22) und einen in einer dritten Richtung angeordneten Source-/Drain-dotierten Bereich (21) umfasst, wobei der Source-/Drain-dotierte Bereich (21) an zwei Seiten des Kanalbereichs (22) angeordnet ist und die dritte Richtung parallel zur Oberfläche des Substrats (11) verläuft.

7. Halbleiterstruktur nach Anspruch 6, wobei
jede der mehreren horizontalen Signalleitungen (3) eine Bitleitung und jede der mehreren vertikalen Signalleitungen (4) eine Wortleitung ist,
die Bitleitung mit dem Source/Drain-dotierten Bereich (21) und die Wortleitung mit dem Kanalbereich (22) verbunden ist; und
mindestens einer der mehreren führenden Drahtpfosten (5) den Source/Drain-dotierten Bereich (21) in mindestens einer der Speicherzellen (TC) durchdringt, wobei
der Source/Drain-dotierte Bereich (21) einen ersten Source/Drain-dotierten Bereich (211) und einen zweiten Source/Drain-dotierten Bereich (212) umfasst, wobei der erste Source/Drain-dotierte Bereich (211) zwischen der Bitleitung und dem Kanalbereich (22) und der zweite Source/Drain-dotierte Bereich (212) an einer Seite des Kanalbereichs (22) gegenüber dem ersten Source/Drain-dotierten Bereich (211) angeordnet ist; und
der führende Drahtpfosten (5) den ersten Source/Drain-dotierten Bereich (211) durchdringt.

8. Halbleiterstruktur nach Anspruch 6, wobei
jede der mehreren horizontalen Signalleitungen (3) eine Wortleitung und jede der mehreren vertikalen Signalleitungen (4) eine Bitleitung ist,
die Bitleitung mit dem Source-/Drain-dotierten Bereich (21) und die Wortleitung mit dem Kanalbereich (22) verbunden ist; und
mindestens einer der mehreren führenden Drahtpfosten (5) den Kanalbereich (22) in mindestens einer der Speicherzellen (TC) durchdringt.

9. Halbleiterstruktur nach Anspruch 6, wobei die Speicherzelle (TC) ferner einen Bitleitungskontaktbereich (23) umfasst, wobei der Bitleitungskontaktbereich (23) die Bitleitung mit dem Source/Drain-dotierten Bereich (21) verbindet,
wobei mindestens einer der mehreren führenden Drahtpfosten (5) den Bitleitungskontaktbereich (23) in einer der Speicherzellen (TC) durchdringt.

10. Halbleiterstruktur nach Anspruch 9, wobei
die Anzahlen der Speicherzellen (TC), die die mindestens zwei führenden Drahtpfosten (5) durchdringen, voneinander verschieden sind.

11. Halbleiterstruktur nach Anspruch 1, wobei
zwei benachbarte führende Drahtpfosten (5) der mehreren führenden Drahtpfosten (5) mindestens durch eine der mehreren Speicherzellengruppen (TCO) beabstandet sind, wobei
die Anzahl der Speicherzellen (TC) zwischen den beiden benachbarten führenden Drahtpfosten (5) fest ist oder die Fläche eines direkt gegenüberliegenden Bereichs zwischen den beiden benachbarten führenden Drahtpfosten (5) direkt proportional zur Anzahl der Speicherzellengruppen (TCO) zwischen den beiden benachbarten führenden Drahtpfosten (5) ist.

12. Halbleiterstruktur nach Anspruch 1, wobei
die Anzahl der gestapelten Strukturen größer als eins ist, die Vielzahl horizontaler Signalleitungen (3) einer gleichen gestapelten Struktur eine erste horizontale Signalleitung bis eine N-te horizontale Signalleitung umfasst, die nacheinander in der zweiten Richtung angeordnet sind, wobei N eine positive ganze Zahl größer als 1 ist; und
zwei gestapelte Strukturen der gestapelten Strukturen ferner eine Vielzahl von Drähten (7) umfassen, wobei jeder Draht (7) zwei führende Drahtpfosten (5) der Vielzahl von führenden Drahtpfosten (5) verbindet, die mit verschiedenen gestapelten Strukturen der gestapelten Strukturen in Kontakt stehen, und wobei eine Summe der Sequenznummern der beiden horizontalen Signalleitungen (3), die elektrisch mit den beiden führenden Drahtpfosten (5) verbunden sind, N+1 beträgt.

13. Halbleiterstruktur nach Anspruch 1, wobei die mindestens zwei führenden Drahtpfosten (5) der mehreren führenden Drahtpfosten (5) mit verschiedenen Speicherzellen (TC) in derselben Speicherzellengruppe (TCO) in Kontakt stehen.

14. Verfahren zur Herstellung einer Halbleiterstruktur, umfassend:
Bereitstellen eines Substrats,
Ausbilden mindestens einer gestapelten Struktur auf dem Substrat, wobei die gestapelte Struktur eine Vielzahl von Speicherzellengruppen umfasst, die in einer ersten Richtung angeordnet sind, wobei jede der Speicherzellengruppen mehrere Schichten von Speicherzellen umfasst, die in einer zweiten Richtung angeordnet sind; und
die erste Richtung parallel zu einer Oberfläche des Substrats (11) verläuft und die zweite Richtung senkrecht zu der Oberfläche des Substrats (11) steht;
die gestapelte Struktur ferner eine Vielzahl horizontaler Signalleitungen (3) und eine Vielzahl vertikaler Signalleitungen (4) umfasst, wobei die Vielzahl horizontaler Signalleitungen (3) in der zweiten Richtung angeordnet ist und sich entlang der ersten Richtung erstreckt, und jede der horizontalen Signalleitungen (3) mit einer Schicht von Speicherzellen (TC) verbunden ist, und wobei die vertikalen Signalleitungen (4) sich entlang der zweiten Richtung erstrecken und mit mehreren Schichten von Speicherzellen (TC) in derselben Speicherzellengruppe (TCO) verbunden sind;
**gekennzeichnet durch**
eine Vielzahl von führenden Drahtpfosten (5), wobei mindestens zwei führende Drahtpfosten (5) der Vielzahl von führenden Drahtpfosten (5) jeweils mit unterschiedlichen Schichten von Speicherzellen (TC) in unterschiedlichen Speicherzellengruppen (TCO) in Kontakt stehen, wobei die mindestens zwei führenden Drahtpfosten den Raum unterschiedlicher Speicherzellengruppen (TCO) nutzen; und
die führenden Drahtpfosten (5) elektrisch mit den horizontalen Signalleitungen (3) verbunden sind.

## Revendications

1. Structure semi-conductrice, comprenant :
un substrat (11) sur lequel est prévue au moins une structure empilée, la structure empilée comprenant une pluralité de groupes de cellules mémoire (TCO) agencés selon une première direction, chaque groupe de cellules mémoire (TCO) comprenant de multiples couches de cellules mémoire (TC) agencées selon une deuxième direction ; et
la première direction est parallèle à une surface du substrat (11), et la deuxième direction est perpendiculaire à la surface du substrat (11) ;
la structure empilée comprend en outre une pluralité de lignes de signal horizontales (3) et une pluralité de lignes de signal verticales (4), dans laquelle la pluralité de lignes de signal horizontales (3) sont agencées selon la deuxième direction et s'étend selon la première direction, et chaque ligne de signal horizontale (3) est connectée à une couche de cellules mémoire (TC), et les lignes de signal verticales (4) s'étendent selon la deuxième direction et sont connectées à multiples couches de cellules mémoire (TC) d'un même groupe de cellules mémoire (TCO) ;
**caractérisée par** :
une pluralité de piliers de connexion conducteurs (5), dans laquelle au moins deux piliers de connexion conducteurs (5) de la pluralité de piliers de connexion conducteurs (5) sont respectivement en contact avec différentes couches de cellules mémoire (TC) dans différents groupes de cellules mémoire (TCO), les au moins deux piliers de connexion utilisent l'espace de différents groupes de cellules mémoire (TCO) ; et
les piliers de connexion conducteurs (5) sont électriquement connectés aux lignes de signal horizontales (3).

2. Structure semi-conductrice selon la revendication 1, dans laquelle
les piliers de connexion conducteurs (5) sont agencés selon la première direction.

3. Structure semi-conductrice selon la revendication 1, dans laquelle
toutes les cellules mémoire (TC) d'un même groupe de cellules mémoire (TCO) sont en contact avec au plus un pilier de connexion conducteur (5) parmi la pluralité de piliers de connexion conducteurs (5).

4. Structure semi-conductrice selon la revendication 1, dans laquelle
le nombre de la pluralité de piliers de connexion conducteurs (5) est supérieur ou égal au nombre de couches de cellules mémoire (TC), et chaque couche de cellules mémoire (TC) comprend au moins une cellule mémoire (TC) en contact avec un pilier de connexion conducteur (5) correspondant.

5. Structure semi-conductrice selon la revendication 1, dans laquelle
le nombre de piliers de connexion conducteurs (5) en contact avec un groupe de cellules mémoire (TCO) est inférieur au nombre de couches de cellules mémoire (TC) dans le groupe de cellules mémoire (TCO).

6. Structure semi-conductrice selon la revendication 1, dans laquelle
chaque cellule mémoire (TC) comprend une région de canal (22) et une région dopée source/drain (21) agencées selon une troisième direction, la région dopée source/drain (21) est agencée sur deux cotés de la région de canal (22), et la troisième direction est parallèle à la surface du substrat (11).

7. Structure semi-conductrice selon la revendication 6, dans laquelle
chacune de la pluralité de lignes de signal horizontales (3) est une ligne de bit, et chacune de la pluralité de lignes de signal verticales (4) est une ligne de mot,
la ligne de bit étant connectée à la région dopée source/drain (21), et la ligne de mot est connectée à la région de canal (22) ; et
au moins un de la pluralité de piliers de connexion conducteurs (5) traverse la région dopée source/drain (21) d'au moins une des cellules mémoire (TC), dans laquelle :
la région dopée source/drain (21) comprend une première région dopée source/drain (211) et une seconde région dopée source/drain (212), la première région dopée source/drain (211) est située entre la ligne de bit et la région de canal (22), et la seconde région dopée source/drain (212) est située du côté opposé de la région de canal (22) par rapport à la première région dopée source/drain (211) ; et
le pilier de connexion conducteur (5) traverse la première région dopée source/drain (211).

8. Structure semi-conductrice selon la revendication 6, dans laquelle
chacune de la pluralité de lignes de signal horizontales (3) est une ligne de mot, et chacune de la pluralité de lignes de signal verticales (4) est une ligne de bit,
la ligne de bit étant connectée à la région dopée source/drain (21), et la ligne de mot est connectée à la région de canal (22) ; et
au moins un de la pluralité de piliers de connexion conducteurs (5) traverse la région de canal (22) d'au moins une des cellules mémoire (TC).

9. Structure semi-conductrice selon la revendication 6, dans laquelle la cellule mémoire (TC) comprend en outre une zone de contact de ligne de bit (23), la zone de contact de ligne de bit (23) reliant la ligne de bit à la région dopée source/drain (21),
dans laquelle au moins un de la pluralité de piliers de connexion conducteurs (5) traverse la zone de contact de ligne de bit (23) dans une des cellules mémoire (TC).

10. Structure semi-conductrice selon la revendication 9, dans laquelle
les nombres de cellules mémoire (TC) que traversent les au moins deux piliers de connexion conducteurs (5) sont différents les uns des autres.

11. Structure semi-conductrice selon la revendication 1, dans laquelle
deux piliers de connexion conducteurs adjacents (5) parmi la pluralité de piliers de connexion conducteurs (5) sont espacés d'au moins un de la pluralité de groupes de cellules mémoire (TCO), dans laquelle :
le nombre de cellules mémoire (TC) situées entre les deux piliers de connexion conducteurs adjacents (5) est fixe, ou, l'aire d'une région directement en regard entre les deux piliers de connexion conducteurs adjacents (5) est directement proportionnelle au nombre de groupes de cellules mémoire (TCO) situés entre les deux piliers de connexion conducteurs adjacents (5).

12. Structure semi-conductrice selon la revendication 1, dans laquelle
le nombre de structures empilées est supérieur à un, la pluralité de lignes de signal horizontales (3) d'une même structure empilée comprend une première ligne de signal horizontale à une N-ième ligne de signal horizontale agencées successivement selon la deuxième direction, N étant un entier positif supérieur à 1 ; et
deux structures empilées parmi les structures empilées comprennent en outre une pluralité de fils conducteurs (7), chaque fil conducteur (7) reliant deux piliers de connexion conducteurs (5), qui sont en contact avec des structures empilées différentes, de la pluralité de pliers de connexion conducteurs (5), et la somme des indices de séquence des deux lignes de signal horizontales (3) électriquement connectées aux deux piliers de connexion conducteurs (5) étant égale à N+1.

13. Structure semi-conductrice selon la revendication 1, dans laquelle les au moins deux piliers de connexion conducteurs (5) parmi la pluralité de piliers de connexion conducteurs (5) sont en contact avec différentes cellules mémoire (TC) dans un même groupe de cellules mémoire (TCO).

14. Procédé de fabrication d'une structure semi-conductrice, consistant à :
fournir un substrat ;
fournir au moins une structure empilée sur le substrat, la structure empilée comprenant une pluralité de groupes de cellules mémoire agencés selon une première direction, chaque groupe de cellules mémoire comprenant de multiples couches de cellules mémoire agencées selon une deuxième direction ; et
la première direction est parallèle à une surface du substrat (11), et la deuxième direction est perpendiculaire à la surface du substrat (11) ;
la structure empilée comprend en outre une pluralité de lignes de signal horizontales (3) et une pluralité de lignes de signal verticales (4), dans laquelle la pluralité de lignes de signal horizontales (3) sont agencées selon la deuxième direction et s'étend selon la première direction, et chaque ligne de signal horizontale (3) est connectée à une couche de cellules mémoire (TC), et les lignes de signal verticales (4) s'étendent selon la deuxième direction et sont connectées à multiples couches de cellules mémoire (TC) d'un même groupe de cellules mémoire (TCO) ;
**caractérisée par** :
une pluralité de piliers de connexion conducteurs (5), dans laquelle au moins deux piliers de connexion conducteurs (5) de la pluralité de piliers de connexion conducteurs (5) sont respectivement en contact avec différentes couches de cellules mémoire (TC) dans différents groupes de cellules mémoire (TCO), les au moins deux piliers de connexion utilisent l'espace de différents groupes de cellules mémoire (TCO) ; et
les piliers de connexion conducteurs (5) sont électriquement connectés aux lignes de signal horizontales (3).
